(19) Europäisches Patentamt

European Patent Office

Office européen des brevets

(11) EP 0 525 528 B1

(12) EUROPÄISCHE PATENTSCHRIFT

(45) Veröffentlichungstag und Bekanntmachung des Hinweises auf die Patenterteilung:
13.11.1996 Patentblatt 1996/46

(51) Int Cl.⁶: **G02B 27/00, H01S 3/00**

(21) Anmeldenummer: 92112145.5

(22) Anmeldetag: 16.07.1992

(54) **Anordnung zur Kohärenzreduktion und Strahlformung eines Laserstrahls**

Arrangement for the coherence reduction and the formation of a laser beam

Arrangement pour la réduction de la cohérence et la formation d'un faisceau laser

(84) Benannte Vertragsstaaten:
DE FR NL

(30) Priorität: 23.07.1991 DE 4124311

(43) Veröffentlichungstag der Anmeldung:
03.02.1993 Patentblatt 1993/05

(73) Patentinhaber: **Firma Carl Zeiss**
**D-73446 Oberkochen (DE)**

(72) Erfinder: **Wangler, Johannes**
**W-7923 Königsbronn (DE)**

(56) Entgegenhaltungen:
**DE-B- 1 497 580**          **US-A- 5 005 969**

## Beschreibung

Die Erfindung betrifft eine Anordnung zur Kohärenzreduktion und Strahlformung eines Laserstrahls.

Eine Anordnung zur Kohärenzreduktion ist aus US 4 744 615 bekannt in einer Ausführung mit einem Licht-Tunnel. Das Licht muß divergent in den Licht-Tunnel eingespeist werden und verläßt diesen stark divergent.

Aus J. Wangler, J. Liegl, Proc. ELO II Vol. 1138, p. 129, Paris 1989 sind verschiedene Alternativen, bewegte Streuscheibe, Linsenarray und nichtabbildender Konzentrator ähnlich oben genannter US-Schrift bekannt. Außerdem ist darin die Verwendung bzw. der Bedarf für die UV-Lithografie beschrieben.

In US 4 686 542 wird zur Aufspaltung eines Laserstrahls in mehrere getrennte parallele Bündel für einen Rasterdrucker die Verwendung einer Planplatte mit einseitiger Vollverspiegelung und einseitiger Teilverspiegelung mit seitwärts stufenweise reduziertem Reflexionsgrad beschrieben.

Es ist Aufgabe der Erfindung, eine Anordnung zur Kohärenzreduktion und Strahlformung eines Laserstrahls mit wenigen und feststehenden optischen Elementen anzugeben, welches die geringe Divergenz des Laserstrahls im wesentlichen nicht verändert. Sie soll zur Verwendung in einer Beleuchtungseinrichtung zur Lithografie im tiefen Ultraviolett geeignet sein und Speckle-Effekte reduzieren. Der Strahlquerschnitt darf bzw. soll durch die Anordnung verändert werden, bzw. nach Bedarf geformt werden.

Diese Aufgabe wird gelöst durch eine gattungsgemäße Anordnung mit den kennzeichnenden Merkmalen des Anspruchs 1.

Vorteilhafte Weiterbildungen sind Gegenstand der Unteransprüche 2 bis 10.

Demnach sind zwei zumindest annähernd parallele Spiegel annähernd senkrecht zum Laserstrahl angeordnet. Ein Spiegel ist teilverspiegelt, der andere möglichst voll. Das austretende Lichtbündel besteht aus mehreren nebeneinander anschließenden oder sich teilweise überlappenden Teilbündeln, die unterschiedlich oft in der Anordnung gespiegelt wurden. Der Abstand der Spiegel ist größer als die halbe Kohärenzlänge des Lasers, der Gangunterschied zweier Teilbündel also jeweils größer als die ganze Kohärenzlänge. Die Kohärenzlänge errechnet sich aus der spektralen Verteilung.

Der Laserstrahl wird etwas gegen die Senkrechte zur Spiegelebene geschwenkt und so wird erreicht, daß die mehrfach reflektierten Bündel seitwärts versetzt durch den teilverspiegelten Spiegel treten.

Der Laserstrahl kann vorteilhaft sowohl neben dem vollverspiegelten Spiegel als auch durch den teilverspiegelten Spiegel eintreten.

Zur Homogenisierung des austretenden Lichtbündels ist es vorteilhaft, wenn der teilverspiegelte Spiegel über seine Breite unterschiedlich verspiegelt ist, wobei der Reflexionsgrad stufenweise oder stetig variieren kann.

In einer Alternative zur Erfindung können die Spiegel auf zwei durch Luft, Gas oder Vakuum getrennten Trägern, von denen einer transparent ist, angebracht sein. Gemäß der Erfindung sind die Spiegel auf beiden Seiten einer planparallelen transparenten Platte, insbesondere aus Glas, angebracht.

Die Geometrie kann so ausgelegt werden, daß die austretenden Teilbündel gerade seitwärts aneinander anschließen. Bei einem Laserstrahl mit zum Rand abnehmender Intensität kann jedoch durch ein Überlappen der Teilbündel das austretende Lichtbündel homogener gemacht werden.

Eine weitere vorteilhafte Möglichkeit der Homogenisierung des austretenden Lichtbündels ergibt sich, wenn der Reflexionsgrad des teilverspiegelten Spiegels so variiert wird, daß er die Inhomogenität der Laserintensität in jedem austretendem Teilbündel zumindest teilweise kompensiert.

Der bei marktüblichen Excimer-Lasern übliche rechteckige Strahlquerschnitt kann leicht annähernd quadratisch gemacht werden, was für die Auslegung von Linsenoptiken vorteilhaft ist.

Zur sicheren Kohärenzreduktion bei nützlicher Bündelaufweitung und mit realistischen Spiegeleigenschaften ist es vorteilhaft, wenn die Zahl der Spiegelungen am vollverspiegelten Spiegel der erfindungsgemäßen Anordnung zwischen 5 und 20 beträgt.

Für einen zur Lithografie im fernen Ultraviolett geeigneten KrF-Excimerlaser ist die typische Kohärenzlänge 20 mm, so daß eine Spiegelanordnung mit mehr als halb so großem Abstand, wie im Kennzeichen des Hauptanspruches gefordert, ohne weiteres zu realisieren ist.

Im weiteren wird die Erfindung anhand der Zeichnung näher erläutert.

Es zeigen

Fig. 1     eine Aufsicht auf eine Alternative zur Erfindung;

Fig. 2     ausschnittsweise eine perspektivische Ansicht dieser Alternative

Fig. 3     ein erfindungs gemäßes Ausführungsbeispiel mit beidseitig verspiegeltem transparentem Träger in einer Laser-Beleuchtungsanordnung;

Fig. 4    ein Diagramm des Reflexionskoeffizienten über die Breite des teilreflektierenden Spiegels für zwei Beispiele;

Fig. 5    eine Skizze zur überlappenden Anordnung der austretenden Teilbündel bei einem Laserbündel mit zum Rand abfallender Intensität.

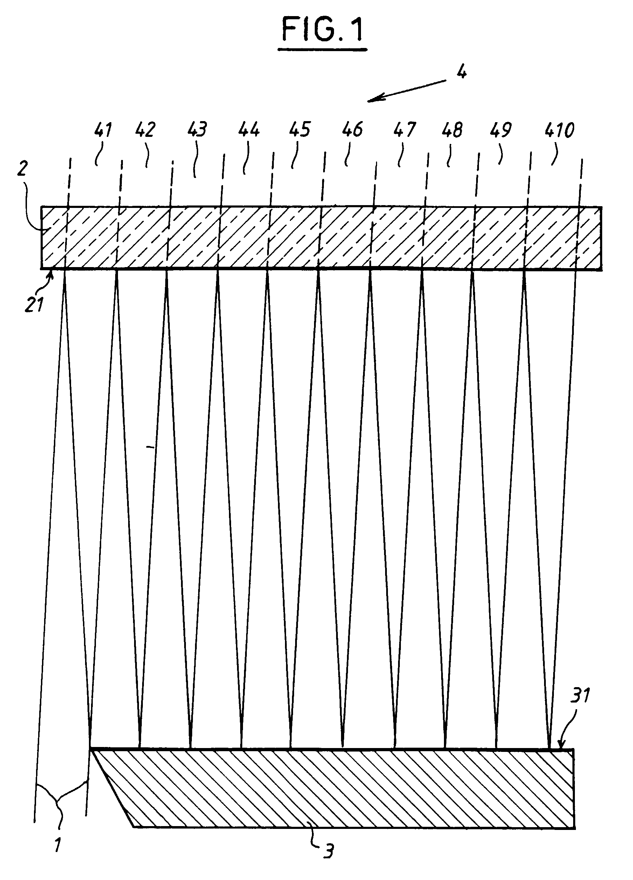

Figur 1 zeigt einen Laserstrahl (1), z.B. einen KrF-Excimer-Laserstrahl mit 248 nm Wellenlänge, einer Kohärenzlänge von 20 mm und mit 2 mm Breite bei 20 mm Höhe.

Der Laserstrahl (1) trifft unter einem Winkel von knapp 4° zur Senkrechten auf einen Planspiegel (2) aus einem transparenten Träger und einer teilverspiegelten Schicht (21).

Gegenüber dem Planspiegel (2), parallel dazu und direkt neben dem Laserstrahl (1) ist ein zweiter Planspiegel (3) mit einer voll spiegelnden Schicht (31) auf einen Träger angeordnet. Der Abstand der Spiegel (2) und (3) beträgt knapp 20 mm und ist damit fast so groß wie die Kohärenzlänge des Laserstrahls (1).

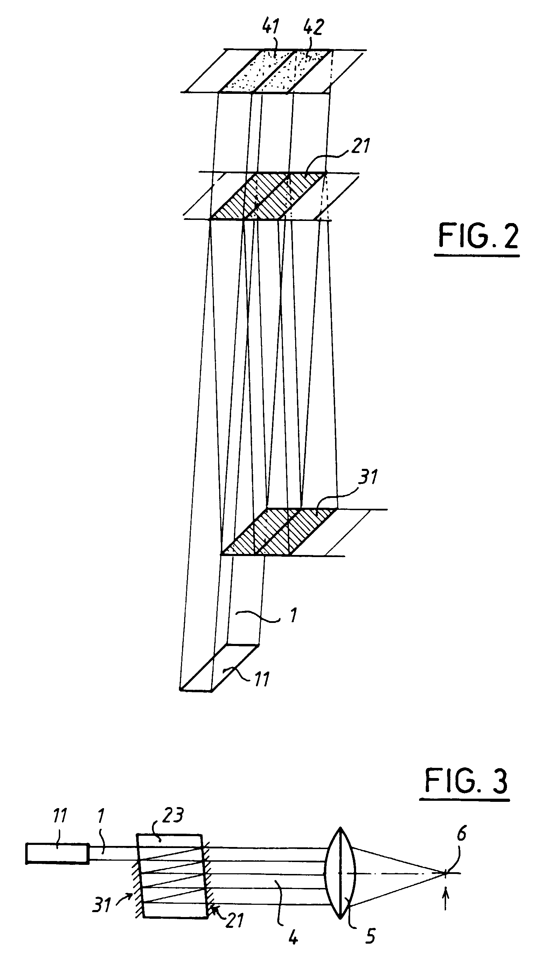

Durch den teilverspiegelten Spiegel (2) tritt so ein Lichtbündel (4) aus, das aus den zehn Teilbündeln (41) bis (410) besteht, die jeweils direkt nebeneinander anschließend parallel austreten. Das Lichtbündel (4) hat dann quadratischen Querschnitt von 20 x 20 mm². Die Laufwegdifferenz zwischen je zwei Teilbündeln (41, 42 usw.) beträgt etwa 40 mm, ist also doppelt so groß wie die Kohärenzlänge des Laserstrahls (1). Die Teilbündel (41, 41 usw.) sind damit kohärenzmäßig völlig entkoppelt. In Figur 2 ist dieses Beispiel ausschnittweise nochmals perspektivisch dargestellt. Die Teilbündel (41, 42) schließen ohne Lücke seitwärts aneinander an.

Figur 3 zeigt eine Laser-Beleuchtungseinrichtung mit einer erfindungs gemäßen Anordnung zur Kohärenzreduktion. Der Laser (11) emittiert einen Laserstrahl (1) von beschränktem Querschnitt, welcher in eine Anordnung mit teilverspiegeltem Spiegel (21) und vollverspiegeltem Spiegel (31) eingespeist wird. Die Anordnung verwendet einen einzigen transparenten Trägers (21) mit beidseitigen Reflexionsschichten (21, 31).

Das austretende Lichtbündel (4) hat bei gleicher Divergenz wie der Laserstrahl (1) einen viel größeren Querschnitt (zehnfach) und ist kohärenzreduziert. Die Fokussierung durch eine Linse (5) ergibt damit einen Fokusfleck (6), in dem Speckle-Effekte durch die Kohärenzreduktion reduziert sind und die Fleckgröße reduziert bzw. die Energiedichte erhöht ist durch den größeren Querschnitt des fokussierten Bündels (4).

Um dies insgesamt wirksam zu erreichen, muß jedoch auch die Lichtintensität über den Querschnitt des austretenden Bündels (4) möglichst homogen sein.

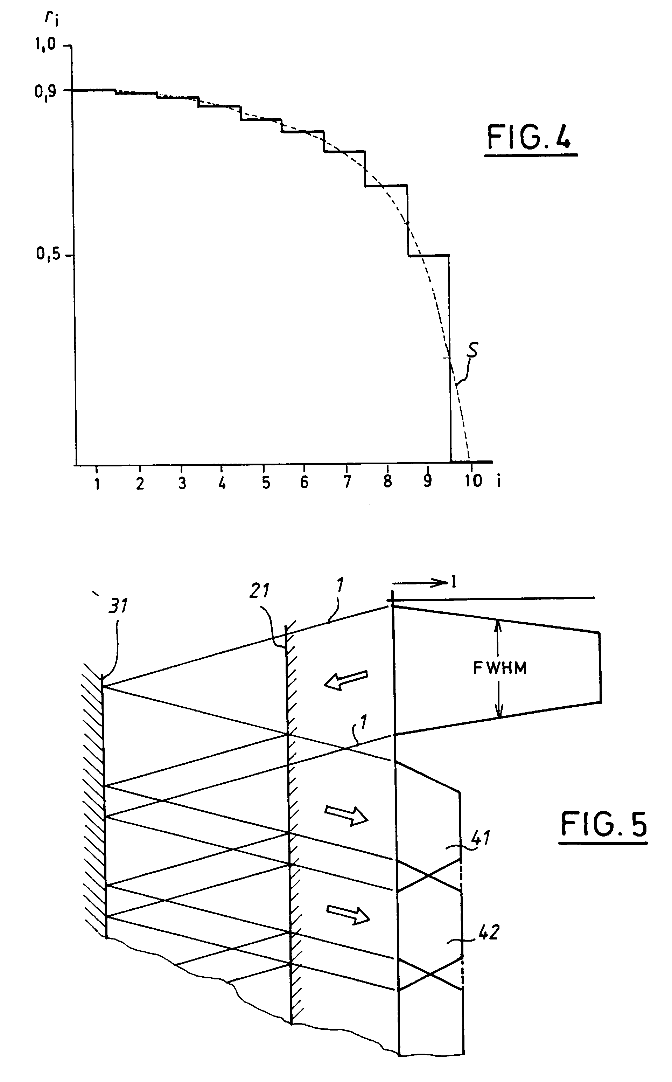

Zunächst ist dabei die mit jeder Reflexion und teilweisen Transmission am teilverspiegelten Spiegel (21) einhergehende Intensitätsänderung des am teilverspiegelten Spiegel (21) ankommenden Bündels zu kompensieren. Dazu ist der Reflexionsgrad stufenweise zu reduzieren. Figur 4 zeigt dies in einer Version mit idealem Reflexionsgrad R = 100 % des vollverspiegelten Spiegels (31) und mit 10 austretenden Teilbündeln (41) bis (410) entsprechend Figur 1.

Für 10 Teilbündel (41 - 410) (i = 1 bis 10) soll jedem 10 % der Laserstrahlintensität $I_o$ zukommen, so daß der Reflexionsgrad $r_i$, über die Breite eines Teilbündels i jeweils konstant gewählt wird und von 0,9 im Bereich des Teilbündels (41) (i = 1) progressiv abnimmt zu 0,5 beim Teilbündel (49) (i = 9) und 0 beim Teilbündel (410) (i = 10).

bei:

n =    Anzahl der Teilbündel (41 bis 410)

$I_o$ =    eingestrahlte Anfangsintensität

R =    Reflektivität des vollverspiegelten Spiegels (31) (R ≈ 1.00)

$r_i$ =    Reflektivität des teilverspiegelten Spiegels (21) am Ort des i-ten Teilbündels.

$I_i^t$ =    i-te transmittierte Intensität.

$I_i^R$ =    i-te reflektierte Intensität.

Dann gilt:

$$\text{Gl. 1} \qquad r_i = \frac{1}{R} \left( 1 - \frac{I_i^{\,t}}{I_{i-1}^{\,R}} \right) \qquad i = 1 \ldots n$$

Gl. 2 $\quad$ mit $I_i^{R} = r_i \cdot I_{i-1}^{R} \cdot R$ .

Es gilt insbesondere für $I_i^{t} = \text{konst} = \frac{I_o}{n}$

$$\text{Gl. 1a)} \qquad r_i = \frac{1}{R} \left( 1 - \frac{I_o}{n \cdot I_{i-1}^{\,R}} \right)$$

Beispiel für $I_o = 1$; $R = 100\,\%$ und $n = 10$:

| i | $r_i$ | $I_i^{R}$ | $I_i^{t}$ |
|---|-------|-----------|-----------|
| 1 | 0.900 | 0.900 | 0.1 |
| 2 | 0.889 | 0.800 | 0.1 |
| 3 | 0.875 | 0.700 | 0.1 |
| 4 | 0.857 | 0.600 | 0.1 |
| 5 | 0.833 | 0.500 | 0.1 |
| 6 | 0.800 | 0.400 | 0.1 |
| 7 | 0.750 | 0.300 | 0.1 |
| 8 | 0.667 | 0.200 | 0.1 |
| 9 | 0.500 | 0.100 | 0.1 |
| 10 | 0.000 | 0.000 | 0.1 |
| | | | Summe = $\overline{1.0}$ |

Statt der stufenweisen Minderung des Reflexionsgrads kann in brauchbarer Näherung auch eine in Figur 4 ebenfalls angegebene stetige Ausgleichskurve (S) verwendet werden, wenn der Herstellungs- und Justieraufwand, der mit den Stufen im Reflexionsgrad einhergeht, gemindert werden soll. Zur Kompensation von Inhomogenitäten der Intensität des Laserstrahls (1) kann der Reflexionsgrad jedoch auch speziell angepaßte Kurven aufweisen.

Einen einfachen Ausgleich des typischen Intensitätsabfalls zum Rand des Laserstrahls (1) hin (Gauß-Profil) erhält man, wie Figur 5 zeigt, durch teilweises Überlappen der austretenden Teilbündel (41, 42 usw.). Das ist durch geeignete Wahl von Abstand der Spiegel (21, 31) und Einfallswinkel des Laserstrahls (1) möglich. Der Abstand der gleichen Kanten benachbarter Teilbündel (41, 42 usw.) variiert zweckmäßigerweise zwischen der vollen Bündelbreite des Laserstrahls (1) (wie Fig. 1) und der vollen Halbwertsbreite FWHM des Laserstrahls (1). In diesem Fall ist es vorteilhaft, wie in Figur 5 dargestellt, den Laserstrahl durch den teilreflektierenden Spiegel (21) eintreten zu lassen, da bei einer Ausführung nach Figur 1 - Eintritt neben dem vollverspiegelten Spiegel (21) - sonst Vignettierung an der Spiegelkante auftreten würde.

Die Zahl der mit der Anordnung erzeugten Teilbündel (41) bis (410), die das austretende Lichtbündel (4) bilden, wird zweckmäßig mit etwa 5 bis 20 angesetzt. Größe und Abstand der Spiegel (21, 31), der Eintrittswinkel des Laserstrahls (1) und der Verlauf des Reflexionsgrads des teilverspiegelten Spiegels (21) werden dementsprechend abgestimmt. Nach oben limitieren diese Zahl die unvermeidlichen Reflexions- und Streuverluste (u.a. am vollverspiegelten Spiegel (31)) und die brauchbaren Querschnitte des austretenden Lichtbündels (4). Mit weniger Reflexionen ist der Effekt der Kohärenzreduktion noch zu gering, da ja jedes Teilbündel (41 usw.) in sich die Kohärenzeigenschaften des Laserstrahls (1) noch aufweist. Ebenfalls ist die Homogenisierung des Intensitätsprofils noch gering.

Die erfindungsgemäße Anordnung kann einzeln, mehrfach und in Kombination mit bekannten Maßnahmen zur Kohärenzreduktion und Homogenisierung, wie z.B. aus Wangler et al. a.a.o. bekannt, benutzt werden.

Zur Kohärenzreduktion in zwei orthogonalen Richtungen ist eine Kombination zweier gegeneinander um 90° verdrehter erfindungsgemäßer Anordnungen mit zwischengeschalteter anamorphotischer Optik geeignet.

## Patentansprüche

1. Anordnung zur Kohärenz redukzierung und Strahlformung mit einem Laser (11) der einen Laserstrahl (1) mit bestimmter Kohärenzlänge und bestimmter Breite emittiert, mit einem transparenten Tragkörper (23) mit zwei gegenüberliegenden parallelen Planflächen, auf denen ein vollverspiegelter Spiegel (31) und ein teilverspiegelter Spiegel (21) aufgebracht sind, dadurch gekennzeichnet, daß der Winkel der beiden Spiegel (21, 31) zum Laserstrahl (1) und ihr gegen seitiger Abstand so gewählt sind, daß die austretenden Teilbündel (41, 410) unmittelbar nebeneinander anschließen oder teilweise überlappen, so daß sie ein geschlossenes Lichtbündel (4) bilden, und daß der Abstand der beiden Spiegel (21, 31) größer als die halbe Kohärenzlänge ist.

2. Anordnung nach Anspruch 1, dadurch gekennzeichnet, daß der Laserstrahl (1) unter einem kleinen Winkel gegen die Senkrechte zur Spiegelebene (21) eintritt.

3. Anordnung nach Anspruch 1 oder 2, dadurch gekennzeichnet, daß der Laserstrahl (1) neben dem vollverspiegelten Spiegel (31) eintritt.

4. Anordnung nach Anspruch 1, 2 oder 3, dadurch gekennzeichnet, daß der Laserstrahl (1) durch den teilverspiegelten Spiegel (21) eintritt.

5. Anordnung nach mindestens einem der Ansprüche 1 - 4, dadurch gekennzeichnet, daß der teilverspiegelte Spiegel (21) über seine Breite unterschiedlich verspiegelt ist.

6. Anordnung nach Anspruch 5, dadurch gekennzeichnet, daß der teilverspiegelte Spiegel (21) mit stufenweise abnehmendem Reflexionsgrad verspiegelt ist. (Fig. 4)

7. Anordnung nach Anspruch 5, dadurch gekennzeichnet, daß der teilverspiegelte Spiegel (21) mit stetig variierendem Reflexionsgrad verspiegelt ist. (Fig. 4)

8. Anordnung nach Anspruch 7, dadurch gekennzeichnet, daß die Variation des Reflexionsgrads die Inhomogenität der Laserintensität über den Strahlquerschnitt zumindest teilweise kompensiert.

9. Anordnung nach mindestens einem der Ansprüche 1 - 8, dadurch gekennzeichnet, daß der eintretende Laserstrahl (1) einen schmalen rechteckigen Querschnitt hat und das austretende Lichtbündel (4) einen annähernd quadratischen Querschnitt hat.

10. Anordnung nach mindestens einem der Ansprüche 1 - 9, dadurch gekennzeichnet, daß die Zahl der Spiegelungen am vollverspiegelten Spiegel (31) zwischen 5 und 20 beträgt.

## Claims

1. Arrangement for reduction of coherence and for beam shaping with a laser (11) emitting a laser beam (1) of a certain coherence length and a certain width, with a transparent carrier (23) with two opposite parallel plane surfaces, which carry a fully reflective mirror (31) and a partially reflective mirror (21)
characterized in that
the angle of the two mirrors (21, 31) relative to the laser beam (1) and their mutual distance are chosen such that the emerging partial bundles (41, 410) are mutually adjacent or partially overlapping, thus forming an integer light bundle (4), and that the distance of the two mirrors (21, 31) exceeds half of the coherence length.

2. Arrangement according to claim 1, characterized in that the laser beam (1) enters at a small angle with respect to the normal of the mirror plane (21).

3. Arrangement according to claim 1 or 2, characterized in that the laser beam (1) enters besides the fully reflecting mirror (31).

4. Arrangement according to claims 1, 2 or 3, characterized in that the laser beam (1) enters through the partially reflecting mirror (21).

5. Arrangement according to at least one of claims 1-4, characterized in that the partially reflecting mirror (21) is reflectively coated in varying amounts over the width thereof.

6. Arrangement according to claim 5, characterized in that the partially reflecting mirror (21) is coated with a stepwise reduced degree of reflectivity.

7. Arrangement according to claim 5, characterized in that the partially reflecting mirror (21) is coated with a continuously varying degree of reflectivity.

8. Arrangement according to claim 7, characterized in that the variation of the degree of reflectivity at least partially compensates the inhomogeneity of the laser intensity over the beam cross section.

9. Arrangement according to at least one of claims 1-8, characterized in that the entering laser beam (1) has a narrow rectangular cross section and the emanating light bundle (4) has an approximately quadratic cross section.

10. Arrangement according to at least one of claims 1-9, characterized in that the number of reflections at the fully reflective mirror (31) lies between 5 and 20.


**Revendications**

1. Agencement pour la réduction de la cohérence et la formation d'un faisceau laser, avec un laser (11) qui émet un faisceau laser (1) ayant une longueur de cohérence déterminée et une largeur déterminée, avec un corps transparent de support (23) avec deux faces planes parallèles opposées, sur lesquelles sont mis un miroir (31) revêtu d'une couche complètement réfléchissante, et l'angle sur un miroir (21) revêtu d'une couche partiellement réfléchissante,
agencement caractérisé en ce que
l'angle des deux miroirs (21, 31) par rapport au faisceau laser (1) et leur distance mutuelle sont choisis de telle façon que les faisceaux partiels sortant (41, 410) se raccordent directement les uns à côté des autres ou se recouvrent en partie, de telle sorte qu'ils forment un faisceau lumineux fermé (4) et en ce que la distance des deux miroirs (21, 31) est plus grande que la moitié de la longueur de cohérence.

2. Agencement selon la revendication 1,
caractérisé en ce que
le faisceau laser (1) entre sous un petit angle par rapport à la perpendiculaire au plan du miroir (21).

3. Agencement selon la revendication 1 ou 2,
caractérisé en ce que
le faisceau laser (1) entre près du miroir (31) revêtu d'une couche complètement réfléchissante.

4. Agencement selon la revendication 1, 2 ou 3,
caractérisé en ce que
le faisceau laser (1) entre à travers le miroir revêtu d'une couche partiellement réfléchissante (21).

5. Agencement selon l'une au moins des revendications 1 à 4,
caractérisé en ce que
le miroir (21) revêtu d'une couche partiellement réfléchissante réfléchit de façon différente sur toute sa largeur.

6. Agencement selon la revendication 5,
caractérisé en ce que
le miroir (21) revêtu d'une couche partiellement réfléchissante réfléchit avec un degré de réflexion qui décroît par étapes (figure 4).

**7.** Agencement selon la revendication 5,
caractérisé en ce que
le miroir (21) revêtu d'une couche partiellement réfléchissante réfléchit avec un degré de réflexion qui varie constamment (figure 4).

**8.** Agencement selon la revendication 7,
caractérisé en ce que
la variation du degré de réflexion compense le manque d'homogénéité de l'intensité du laser sur la section transversale du faisceau, au moins en partie.

**9.** Agencement selon au moins l'une des revendications 1 à 8,
caractérisé en ce que
le faisceau entrant (1) a une étroite section transversale carrée et le faisceau de lumière sortant (4) a une section transversale approximativement carrée.

**10.** Agencement selon au moins l'une des revendications 1 à 9,
caractérisé en ce que
le nombre des réflexions sur le miroir (31) revêtu d'une couche complètement réfléchissante est comprise entre 5 et 20.

# FIG.1

FIG. 2

FIG. 3

FIG. 4

FIG. 5